# EUROPEAN PATENT SPECIFICATION

(11) **EP 2 150 793 B1**
(45) Date of publication and mention of the grant of the patent: **26.06.2013**
(21) Application number: 08761661.1
(22) Date of filing: 13.05.2008
(51) Int. Cl.: G01L 23/22, G01L 27/00

(54) **INDICATOR ARRANGEMENT**
INDIKATORENANORDNUNG
AGENCEMENT D'INDICATEUR

(30) Priority: 21.05.2007 FI 20075366
(43) Date of publication of application: 10.02.2010
(73) Proprietor: Wärtsilä Finland Oy, 65380 Vaasa (FI)
(72) Inventor: SAIKKONEN, Ari, FI-65200 Vaasa (FI); LAAKSO, Perri, FI-33200 Tampere (FI); KALLIO, Markku, FI-33200 Tampere (FI); SALOJÄRVI, Antero, FI-33200 Tampere (FI)
(74) Representative: Berggren Oy Ab
(86) International application number: PCT/FI2008/050265
(87) International publication number: WO 2008/142200

(56) References cited:
- WO-A-03/019208
- DE-T2- 69 832 980
- JP-A- 58 011 824
- US-A1- 2006 011 169

## Description

### Field of invention

The present invention relates to indicators used in piston-operated internal combustion engines, such as diesel engines or gas engines. The invention especially relates to knock indicators.

### Background art

Many kinds of different indicators are used in piston engines for observing different units and states in engines. The temperature of a cylinder can be measured, the fuel flow to be supplied can be monitored; the engine running speed can be measured and so on. The knocking occurring in a cylinder of an engine can also be monitored.

A cylinder knocks when the air-fuel mixture introduced therein is ignited in an undesired manner. Typically knocking occurs when the air-fuel mixture or the fuel used separately for ignition is ignited too early. Knocking stresses the engine and can damage the engine. Knock control is used to avoid engine knock by controlling the ignition timing and/or fuel injection for each cylinder. Knock control can reduce the engine load. The last alternative is to even turn the engine off in case deemed necessary. It is also possible to recycle exhaust gas back to the engine, whereby the so-called knock margin is increased. Knock margin means the difference between the units of the operating state of the cylinder and the state causing the knock. The larger the margin is, the smaller the probability of the cylinder turning into the knock-causing state.

It is nowadays common to measure the knock by means of an acceleration sensor from the cylinder head, cylinder sleeve or the engine block. The acceleration sensor is typically a piezoresistive crystal. The signal emitted by the sensor is measured at the correct moment (i.e. when the crank rotation angle is suitable) at the time knock most likely occurs. Noise and excess frequencies are filtered from the signal. The processed signal is compared with the reference value, whereby it is possible to deduce whether the cylinder is in a knock state. Such a sensor arrangement is known from US 2006/ 0011169.

If the knock-indicating sensor and the cables connected thereto are not damaged, knocking can be reliably observed. However, if the sensor or the cables connected thereto are damaged, the signal emitted by the sensor can be incorrect. The engine can be incorrectly controlled on the basis of the incorrect signal whereby there is a great risk of damaging the engine. The engine causes vibration that can in the long run damage the sensor, the cables connected thereto or the connections of the cable.

### Brief description of the invention

An aim of the present invention is to reduce the above-mentioned disadvantages. The aim is achieved as described in the main claim. The dependent claims describe the various embodiments of the invention.

The embodiment according to the invention comprises a passive acceleration sensor 1 for forming a voltage signal and filtering means 2 for filtering the said voltage signal. Such an indicator arrangement is for piston engines - usually for detecting knocking in the cylinder of the engine. The indicator arrangement according to the invention also comprises a resistor 4, the first end of which is connected to between the passive acceleration sensor 1 and the filtering means 2 and the other end is connected to the basic voltage level. The connection of the first end of the resistor is also connected to output 5. The indicator arrangement also comprises a direct voltage source 3, the first end of which is connected to a passive acceleration sensor 1 while the second end is connected to the basic voltage level. Voltage can be detected from the output of the indicator arrangement for detecting a fault in the indicator arrangement.

### List of figures

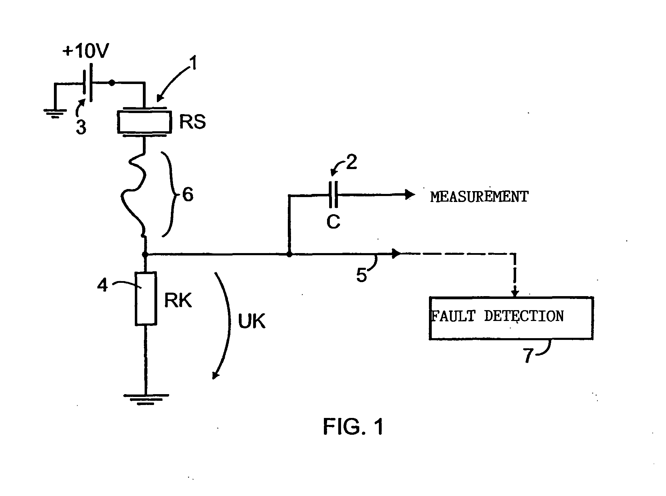

In the following the invention is described in more detail by reference to the figures in the drawing, in which
Figure 1 illustrates an example of the indicator arrangement according to the invention. **Description of the invention**

Figure 1 illustrates an example of an embodiment of the indicator arrangement according to the invention as a simple circuit diagram. It will be obvious to one skilled in the art to carry the apparatus according to the invention out based on the circuit diagram. As has been mentioned above, the indicator arrangement is used in piston-operated internal combustion engines, usually for indicating knocking taking place in the cylinder. The indicator arrangement comprises a passive acceleration sensor 1 for forming a voltage signal and filtering means 2 for filtering the said voltage signal.

In the mode of carrying out of this example, when the indicator arrangement is installed in a piston-operated internal combustion engine, the acceleration sensor is arranged in the cylinder head where it can detect a knocking phenomenon should one occur. The signal sent by the sensor is measured at a suitable moment when knocking is most probable to occur. At this time an undesired force component resulting from burning of fuel and causing knocking has an effect on the cylinder head, which can be detected with an acceleration sensor.

The indicator arrangement also comprises a resistor 4, an output 5 and a DC voltage source 3. The first end of the resistor 4 is connected to between the passive acceleration sensor 1 and the filtering means 2 and the other end is connected to the basic voltage level. The connection of the first end of the resistor (i.e. the node of the electric circuit) is also connected to output 5. The first end of the direct voltage source 3 is connected to the passive acceleration sensor 1 while the second end is connected to the basic voltage level. Voltage can be detected from the output of the indicator arrangement for detecting a fault in the indicator arrangement. A detection apparatus 7 can be connected to the output 5 for detecting a fault in the indicator arrangement.

The example of figure 1 illustrates that there is a connection between the connection of the first end of the resistor 4 and the passive acceleration sensor 1. This connection can be a connection lead 6, which is very descriptive of a real installation. Both the acceleration sensor 1 and the connection lead 6 can be damaged. For example, the vibration of the engine can stress the sensor and/or the connection lead. The connection lead can be metres in length. The connections of the connection lead are also exposed to stresses caused by the vibration of the engine.

In the example of figure 1 the direct voltage source is +10V. The voltage of the direct voltage source is (mainly) divided over the internal resistance RS of the acceleration sensor 1 and the resistance RK of the resistor 4. In this case voltage UK is formed between the first end of the resistor and the basic voltage level, i.e. over the resistor 4. The acceleration sensor has a slight effect on the voltage level UK that is monitored via the output 5. It should be mentioned that the UK direct voltage is monitored at the output.

When the acceleration sensor and the connection lead (with its connections) are operational, the UK direct voltage is on a certain voltage level. For example, if the resistance RS of the acceleration sensor is 4.88 MΩ and the resistance RK of the resistor is 1 MΩ, the voltage UK is in normal state 1.7 V. This voltage level fluctuates in normal state according to the normal operation of the acceleration sensor.

Let's examine a fault situation in which the connection lead 6 is broken so that the lead is in connection with the environment normally having a zero voltage, i.e. in the basic voltage level shown in the figure. In such a case the UK voltage level is reduced even to nearly zero depending on the resistance between the breakage point of the lead and the environment. Another exemplary situation is the internal breakage of the acceleration sensor so that its internal resistance is reduced. Thus the UK voltage level increases.

When certain limit values are set as the lower and upper limit of the UK voltage, the voltage level at the output 5 can be used for deducing whether the indicator arrangement is working correctly or whether there is a fault. The limit value of the lower voltage can be, for example, 1.2 V with a voltage lower than that being considered a fault. The limit value of the upper voltage can be, for example, 2.2 V with a voltage higher than that being considered a fault. The voltage range between the higher and lower voltages is the range of normal operation on which there is no fault. In practice the detection apparatus 7 follows whether values exceed or fall below the limit values on the basis of which a fault alarm can be given. The voltage source, voltage values and resistor values shown here can also differ from what is described here. The choice of suitable values depends, for example, on how high the desired direct voltage is supposed to be.

The passive acceleration sensor 1 can,. for example, be a piezoelectric crystal or an inductive sensor. Filtering means 2 are used for filtering the noise and excess frequencies interfering with the measurement of the knocking from the signal 1 of the acceleration sensor. In the figure the filtering means 2 are illustrated simply as a capacitor, but the filtering means can also comprise other parts, such as resistors.

In the figure, the basic voltage level is shown as zero voltage level, but it will also be possible to use another voltage level as the basic voltage level.

As can be seen, the embodiment according to the invention can be carried out by means of a number of solutions. Thus, it will be apparent that the invention is not limited to the examples mentioned in this text. Thus, any inventive embodiment can be carried out within the scope of the invention.

## Claims

1. An indicator arrangement for piston-operated internal combustion engines comprising a passive acceleration sensor (1) for forming a voltage signal and a filtering means (2) for filtering the said voltage signal.
**characterized in that** the indicator arrangement comprises a resistor (4) the first end of which is connected between a passive acceleration sensor (1) and a filtering means (2) and the other end is connected to a basic voltage level, the connection of the first end of the resistor being also connected to an output (5), the indicator arrangement also comprising a direct voltage, source (3) the first end of which is connected to the passive acceleration sensor (1) and the other end of which is connected to a basic voltage level, thus the passive acceleration sensor (1) and the direct voltage source (3) being in series, the voltage at the output (5) of the indicator arrangement enabling detection of a fault in the indicator arrangement.

2. An arrangement according to claim 1, **characterized in that** a detection apparatus (7) is connected to the output (5) for detecting a fault in the indicator arrangement.

3. An arrangement according to claim 1 or 2, **characterized in that** the passive acceleration sensor is a piezoelectric crystal.

4. An arrangement according to claim 1 or 2, **characterized in that** the passive acceleration sensor is an inductive sensor.

5. An arrangement according to claim 3 or 4, **characterized in that** there is a connection lead (6) between the connection of the first end of the resistor and the passive acceleration sensor.

6. An arrangement according to claim 5, **characterized in that** the basic voltage level is zero voltage level.

## Patentansprüche

1. Anzeigeanordnung für kolbenbetriebene Verbrennungsmotoren, die einen passiven Beschleunigungssensor (1) zum Bilden eines Spannungssignals und ein Filtermittel (2) zum Filtern des Spannungssignals aufweist,
**dadurch gekennzeichnet, dass** die Anzeigeanordnung einen Widerstand (4) aufweist, dessen erstes Ende zwischen einem passiven Beschleunigungssensor (1) und einem Filtermittel (2) angeschlossen ist, und dessen anderes Ende mit einem Basisspannungsniveau verbunden ist, wobei die Verbindung des ersten Endes des Widerstands auch mit einem Ausgang (5) verbunden ist, wobei die Anzeigeanordnung auch eine direkte Spannungsquelle (3) aufweist, deren erstes Ende mit dem passiven Beschleunigungssensor (1) verbunden ist und deren anderes Ende mit einem Basisspannungsniveau verbunden ist, so dass der passive Beschleunigungssensor (1) und die direkte Spannungsquelle (3) in Serie geschaltet sind, wobei die Spannung an dem Ausgang (5) der Anzeigeanordnung das Erfassen eines Fehlers in der Anzeigeanordnung ermöglicht.

2. Anordnung nach Anspruch 1, **dadurch gekennzeichnet, dass** ein Erfassungsgerät (7) mit dem Ausgang (5) zum Erfassen eines Fehlers in der Anzeigeanordnung verbunden ist.

3. Anordnung nach Anspruch 1 oder 2, **dadurch gekennzeichnet, dass** der passive Beschleunigungssensor ein piezoelektrischer Kristall ist.

4. Anordnung nach Anspruch 1 oder 2, **dadurch gekennzeichnet, dass** der passive Beschleunigungssensor ein Induktivsensor ist.

5. Anordnung nach Anspruch 3 oder 4, **dadurch gekennzeichnet, dass** zwischen der Verbindung des ersten Endes des Widerstands und dem passiven Beschleunigungssensor ein Verbindungsdraht (6) besteht.

6. Anordnung nach Anspruch 5, **dadurch gekennzeichnet, dass** das Basisspannungsniveau ein Nullspannungsniveau ist.

## Revendications

1. Montage d'indicateur pour des moteurs à combustion interne actionnés par piston comprenant un capteur d'accélération passif (1) pour former un signal de tension et un moyen de filtrage (2) pour filtrer ledit signal de tension,
**caractérisé en ce que** le montage d'indicateur comprend une résistance (4), dont la première extrémité est reliée entre un capteur d'accélération passive (1) et un moyen de filtrage et l'autre extrémité est reliée à un niveau de tension de base, la connexion de la première extrémité de la résistance étant également reliée à une sortie (5), le montage d'indicateur comprenant également une source de tension directe (3), dont la première extrémité est connectée au capteur d'accélération passive (1) et dont l'autre extrémité est connectée à un niveau de tension de base, le capteur d'accélération passive (1) et la source de tension directe étant ainsi en série, la tension à la sortie (S) du montage d'indicateur activant la détection d'une panne dans le montage de l'indicateur.

2. Montage selon la revendication 1, **caractérisé en ce que** l'appareil de détection (7) est connecté à la sortie (5) pour détecter une panne dans le montage d'indicateur.

3. Montage selon la revendication 1 ou 2, **caractérisé en ce que** le capteur d'accélération passive est un cristal piézoélectrique.

4. Montage selon la revendication 1 ou 2, **caractérisé en ce que** le capteur d'accélération passive est un capteur inductif.

5. Montage selon la revendication 3 ou 4, **caractérisé en ce qu'**il y a un câble de connexion (6) entre la connexion de la première extrémité de la résistance et le capter d'accélération passive.

6. Montage selon la revendication 5, **caractérisé en ce que** le niveau de tension de base est le niveau de tension zéro.
